# EUROPÄISCHE PATENTSCHRIFT

(11) **EP 4 136 052 B1**
(45) Veröffentlichungstag und Bekanntmachung des Hinweises auf die Patenterteilung: **05.03.2025**
(21) Anmeldenummer: 21716282.5
(22) Anmeldetag: 25.03.2021
(51) Int. Cl.: B81B 3/00, B81C 1/00

(54) **VERFAHREN ZUR HERSTELLUNG VON WENIGSTENS EINER ERSTEN UND EINER ZWEITEN MIKROSPIEGELVORRICHTUNG**
METHOD FOR PRODUCING AT LEAST ONE FIRST AND ONE SECOND MICROMIRROR DEVICE
PROCÉDÉ DE PRODUCTION D'AU MOINS UN PREMIER ET UN SECOND DISPOSITIF DE MICRO-MIROIR

(30) Priorität: 17.04.2020 DE 102020204910
(43) Veröffentlichungstag der Anmeldung: 22.02.2023
(73) Patentinhaber: Robert Bosch GmbH, 70442 Stuttgart (DE)
(72) Erfinder: STAHL, Heiko, 72760 Reutlingen (DE); STRAUB, Rainer, 72119 Ammerbuch (DE)
(86) Internationale Anmeldenummer: PCT/EP2021/057719
(87) Internationale Veröffentlichungsnummer: WO 2021/209238

(56) Entgegenhaltungen:
- US-A1- 2005 136 663

## Beschreibung

Die Erfindung betrifft ein Verfahren zur Herstellung von wenigstens einer ersten und einer zweiten Mikrospiegelvorrichtung. Zudem betrifft die Erfindung eine erste und/oder zweite Mikrospiegelvorrichtung, hergestellt mittels des Verfahrens und eine erste und/oder zweite Mikrospiegelvorrichtung, insbesondere hergestellt mittels eines Verfahrens nach einem Ansprüche 1 bis 13, mit einer ersten und/oder zweiten Spiegelplatte, aufweisend jeweils eine Polysiliziumschicht.

### Stand der Technik

Aus dem Dokument WO 2014/064606 A1 ist ein Verfahren zur Herstellung von Mikrospiegeln bekannt. Hierbei wird ein Siliziumoxidwafer verwendet, der zunächst in einem Verfahrensschritt mittels Nassätzen entlang einer Trennebene getrennt wird und in einem weiteren, separaten Verfahrensschritt werden die Spiegelplatten der Mikrospiegel vereinzelt.

Aus dem Dokument US 2005/136663 A1 ist weiterhin ein Verfahren zur Herstellung von Mikrospiegeln bekannt, bei dem zwei Ätzschritte, einer von der Vorderseite und einer von der Rückseite eines Substrats, das Dünnfilmschichten trägt, nacheinander angewendet werden, um einen Mikrospiegel zu bilden.

Ausgehend von diesem Stand der Technik ist es Aufgabe der vorliegenden Erfindung, ein vereinfachtes Verfahren zur Herstellung von Mikrospiegelvorrichtungen zu erzeugen.

### Offenbarung der Erfindung

Ein Verfahren gemäß der Erfindung ist in Anspruch 1 definiert.

Zur Lösung der Aufgabe wird ein Verfahren zur Herstellung von wenigstens einer ersten und einer zweiten Mikrospiegelvorrichtung vorgeschlagen. Mit einer Mikrospiegelvorrichtung ist hierbei insbesondere ein mechanischer Mikrospiegel, also ein Mikrospiegel gemeint, der noch nicht mit der Antriebseinheit des Mikrospiegels verbunden ist. In einem Verfahrensschritt wird ein, insbesondere plattenförmiger, Siliziumwafer mit einer Vorderseite und einer Rückseite bereitgestellt. Mit der Vorderseite des Siliziumwafers ist insbesondere die Seite gemeint, welche in der fertig erzeugten Mikrospiegelvorrichtung in Richtung der, für einfallende Lichtstrahlen reflektierenden Oberfläche der Mikrospiegelvorrichtung ausgerichtet ist. In einem weiteren Verfahrensschritt wird eine Siliziumoxidschicht auf wenigstens die Vorderseite des Siliziumwafers, insbesondere mit einer Schichtdicke der Siliziumoxidschicht in einem Bereich von 1 µm bis 3 µm, thermisch aufgebracht. Insbesondere wird die Siliziumoxidschicht mit einer Schichtdicke von 2 µm aufgebracht. In einem folgenden Verfahrensschritt wird die Siliziumoxidschicht, insbesondere bis zu einer äußeren Oberfläche des Siliziumwafers, derart entfernt, dass wenigstens ein erster Trennbereich und wenigstens ein zweiter Trennbereich der Siliziumoxidschicht erzeugt werden. Der erste und der zweite Trennbereich der Siliziumoxidschicht sind hierbei räumlich voneinander, entlang einer Trennebene getrennt angeordnet. Es besteht entsprechend kein stofflicher Zusammenhalt mehr zwischen dem ersten und zweiten Trennbereich der Siliziumoxidschicht. Bei der Trennebene handelt es sich insbesondere um eine Ebene, die im Wesentlichen senkrecht zu einer äußeren Oberfläche des Silizumwafers angeordnet ist. In einem weiteren Verfahrensschritt wird eine Siliziumschicht, insbesondere eine Polysiliziumschicht mit einer Schichtdicke in einem Bereich von 5 µm bis 50 µm, auf die Vorderseite des Siliziumwafers und auf die Siliziumoxidschicht, insbesondere auf den ersten und zweiten Trennbereich der Siliziumoxidschicht aufgebracht. Die Siliziumschicht ist also unmittelbar in Kontakt mit der Vorderseite des Siliziumwafers, insbesondere mit einer äußerlichen Oberfläche der Vorderseite des Siliziumwafers, und mit der Siliziumoxidschicht, insbesondere mit einer äußeren Oberfläche der Siliziumoxidschicht. Weiterhin wird eine Ätzmaske auf die Rückseite des Siliziumwafers aufgebracht, wobei die Ätzmaske entlang der Trennebene des ersten und zweiten Trennbereichs der Siliziumoxidschicht eine erste Öffnung aufweist. Bei der Ätzmaske handelt es sich insbesondere um eine Hardmaske oder um eine Lackmaske. Insbesondere wird als Ätzmaske eine weitere Siliziumoxidschicht auf die Rückseite des Siliziumwafers aufgebracht. In einem weiteren Verfahrensschritt wird dann die Siliziumschicht, insbesondere ein Teil der Siliziumschicht, und der Silliziumwafer, insbesondere ein Teil des Siliziumwafers, mittels eines Ätzverfahrens abhängig von der Ätzmaske auf der Rückseite des Siliziumwafers und abhängig von der Siliziumoxidschicht des Siliziumwafers, insbesondere des ersten und zweiten Trennbereichs der Siliziumoxidschicht, entfernt, sodass wenigstens eine erste und eine zweite Mikrospiegelvorrichtung erzeugt werden. Die Ätzmaske, wie auch die Siliziumoxidschicht dienen hierbei als Schichten, die das Ätzen stoppen (Ätzstoppschichten). Durch die Verwendung des vorstrukturierten Siliziumoxidwafers innerhalb des hier beschriebenen Verfahrens wird es ermöglicht, den zuletzt beschriebenen Verfahrensschritt, bei dem die Mikrospiegelvorrichtungen voneinander getrennt werden, in einem einzigen Verfahrensschritt auszuführen. Vorzugsweise wird durch das Entfernen der Siliziumschicht, insbesondere des Teils der Siliziumschicht, mittels des Ätzverfahrens wenigstens ein erster Trennbereich und einen zweiter Trennbereich der Siliziumschicht erzeugt. Der erste und der zweite Trennbereich der Siliziumschicht sind hierbei voneinander räumlich, entlang der Trennebene getrennt angeordnet und bilden somit eine erste Spiegelplatte der ersten Mikrospiegelvorrichtung, aufweisend den ersten Trennbereich der Siliziumschicht, und eine zweite Spiegelplatte der zweiten Mikrospiegelvorrichtung, aufweisend den zweiten Trennbereich der Siliziumschicht, aus. Die reflektierenden Oberflächen solcher Spiegelplatten dienen später in einem Mikrospiegel dazu, einfallende Lichtstrahlen, beispielsweise zur Projektion eines Bildes, abzulenken. Solche Spiegelplatten weisen beispielsweise eine Reflexionsfläche von 50mm² bis 200mm² auf. Die Spiegelplatten weisen beispielsweise eine runde, ovale oder rechteckige Form auf. In diesem Zusammenhang wird der erste und der zweite Trennbereich der Siliziumoxidschicht vorzugsweise in Abhängigkeit einer gewünschten jeweiligen Größe und einer jeweiligen Form, insbesondere einer kreisrunden und/oder ovalen und/oder rechteckigen Form, der ersten Spiegelplatte der ersten Mikrospiegelvorrichtung und der zweiten Spiegelplatte der zweiten Mikrospiegelvorrichtung erzeugt. Weiterhin bevorzugt wird durch das Entfernen des Siliziumwafers, insbesondere des Teils des Siliziumwafers, mittels des Ätzverfahrens wenigstens ein erster Trennbereich und einen zweiter Trennbereich des Siliziumwafers erzeugt. Der erste und der zweite Trennbereich des Siliziumwafers sind hierbei voneinander räumlich, entlang der Trennebene getrennt angeordnet. Somit wird eine erste Versteifungsstruktur der ersten Mikrospiegelvorrichtung, aufweisend den ersten Trennbereich des Siliziumwafers und den ersten Trennbereich der Siliziumoxidschicht, und eine zweite Versteifungsstruktur der zweiten Mikrospiegelvorrichtung, aufweisend den zweiten Trennbereich des Siliziumwafers und den zweiten Trennbereich der Siliziumoxidschicht, erzeugt. Eine solche Versteifungsstruktur dient zur Verbindung der Spiegelplatte mit der späteren Antriebseinheit des Mikrospiegels. Die Versteifungsstruktur sollte hierbei zum einen möglichst wenig Gewicht haben, um eine hohe Beweglichkeit des Mikrospiegels zu ermöglichen, zum anderen muss die Versteifungsstruktur der Spiegelplatte auch die nötige Stabilität geben. In diesem Zusammenhang weist die Ätzmaske vorzugsweise weiterhin wenigstens eine zweite Öffnung, insbesondere zur Trennung der ersten Versteifungsstruktur in einen ersten Trennbereich der ersten Versteifungsstruktur und einen zweiten Trennbereich der erste Versteifungsstruktur, auf. Die jeweilige Versteifungsstruktur kann somit als wenigstens zwei zueinander parallel verlaufende Versteifungsstreben aufgebaut werden.

Bevorzugt wird als Ätzverfahren ein Plasmaätzverfahren, insbesondere das DRIE-Ätzverfahren, verwendet. Alternativ wird als Ätzverfahren ein Ionenstrahlätzverfahren verwendet. Die Spiegelplatte, wie auch die Versteifungsstruktur einer Mikrospiegelvorrichtung können somit in einem einzigen Verfahrensschritt erzeugt werden.

Vorzugsweise wird der Siliziumwafer als Rohwafer zu Beginn des Verfahrens mit einer Dicke von im Wesentlichen 300 bis 400 µm bereitgestellt. Der Rohwafer weist in diesem Fall schon zu Beginn des Verfahrens eine Dicke auf, welche die Versteifungsstruktur in der fertigen Mikrospiegelvorrichtung als Zieldicke aufweisen sollte, um die Bedingungen hinsichtlich Gewicht und Stabilität zu erfüllen. Alternativ wird der Siliziumwafer als Rohwafer zu Beginn des Verfahrens mit einer Dicke von im Wesentlichen 725 µm bereitgestellt. In diesem Fall wird vorzugsweise in einem weiteren Verfahrensschritt, welcher auf das Aufbringen der Siliziumschicht, insbesondere der Polysiliziumschicht, auf die Vorderseite des Siliziumwafers und auf die Siliziumoxidschicht folgt, die Rückseite des Siliziumwafers, insbesondere bis zu einem Erreichen einer Zieldicke des Silizumwafers, abgeschliffen. Die Zieldicke entspricht insbesondere einer Schichtdicke in einem Bereich von 300 µm bis 400 µm.

Bevorzugt wird die Siliziumoxidschicht zusätzlich auf die Rückseite des Siliziumwafers thermisch aufgebracht. Die Siliziumxidschicht kann in diesem Fall beispielsweise als Ätzmaske auf der Rückseite verwendet werden, falls der Siliziumwafer als Rohwafer zu Beginn des Verfahrens mit einer Dicke von im Wesentlichen 300 bis 400 µm bereitgestellt wird.

Bevorzugt wird in einem weiteren Verfahrensschritt eine erste Metallschicht, insbesondere eine erste Goldschicht oder eine erste Aluminiumschicht, auf die Siliziumschicht, insbesondere auf eine äußere Oberfläche des ersten Trennbereichs der Siliziumschicht, aufgebracht. Weiterhin wird eine zweite Metallschicht, insbesondere eine zweite Goldschicht oder eine zweite Aluminiumschicht, auf die Siliziumschicht, insbesondere auf eine äußere Oberfläche des zweiten Trennbereichs der Siliziumschicht, aufgebracht. Somit wird der Reflexionsgrad der Spiegelplatte der jeweiligen Mikrospiegelvorrichtung erhöht. Vorzugsweise werden zur Ausrichtung der ersten Metallschicht relativ zu dem ersten Trennbereich der Siliziumoxidschicht und zur Ausrichtung der zweiten Metallschicht relativ zu dem wenigstens zweiten Trennbereich der Siliziumoxidschicht wenigstens zwei Markierungen auf der Siliziumschicht aufgebracht. Die wenigstens zwei Markierungen werden hierbei insbesondere in eine äußere Oberfläche der Siliziumschicht geätzt. Um die Markierungen in der richtigen Position auf die Siliziumschicht aufzubringen, wird insbesondere ein Infrarotmessgerät verwendet, mittels welchem die innerhalb des Schichtstapels vergrabene Struktur des ersten Trennbereichs und des wenigstens zweiten Trennbereichs der Siliziumoxidschicht detektiert werden kann. Die wenigstens zwei Markierungen werden dann insbesondere auf einem Randbereich des Schichtstapels aufgebracht. Somit können die Metallschichten auf der Vorderseite des Siliziumwafers auf die innerhalb des Schichtaufbaus vergrabene Struktur des ersten Trennbereichs und des wenigstens zweiten Trennbereichs der Siliziumoxidschicht hin ausgerichtet werden.

Vorzugsweise wird weiterhin die Siliziumschicht, insbesondere eine äußere Oberfläche des ersten Trennbereichs der Siliziumschicht und eine äußere Oberfläche des zweiten Trennbereichs der Siliziumschicht, unmittelbar oder mittelbar mit einem Klebeband, insbesondere einem einseitigen Klebeband, verbunden. Das Klebeband, welches insbesondere als Bluetape ausgebildet sein kann, dient einerseits zum Transportieren der fertig hergestellten ersten und zweiten Mikrospiegelvorrichtung zu der jeweiligen Antriebseinheit des Mikrospiegels und andererseits zum Stoppen des Ätzprozesses, bei dem ein Teil der Siliziumschicht und des Siliziumwafers entfernt wird.

Bevorzugt wird in einem weiteren Verfahrensschritt die Ätzmaske entfernt. Falls es sich bei der Ätzmaske um eine Lackmaske handelt, wird die Ätzmaske beispielsweise mittels eines Plasmastripps entfernt. Im Falle einer Hardmaske als Ätzmaske kann die Ätzmaske mittels eines Oxidätzprozesses entfernt werden. Falls ein Oxidätzprozess verwendet wird, werden ebenfalls die freiliegenden Teile der Siliziumoxidschicht auf der Vorderseite des Siliziumwafers weggeätzt. Somit kann der Druck der Versteifungsstruktur auf die Spiegelplatte reduziert werden.

Vorzugsweise wird die Siliziumschicht in Form einer Abscheidung von Silizium, insbesondere Polysilizium, auf der Vorderseite des Siliziumwafers und auf der Siliziumoxidschicht, insbesondere auf den ersten und zweiten Trennbereich der Siliziumoxidschicht, und einem darauf folgenden Polierschritt aufgebracht.

### Beschreibung der Zeichnungen

Figuren 1a.1-1a.3 zeigen schematisch die Verfahrensschritte einer ersten Ausführungsform eines Verfahrens zur Herstellung von wenigstens einer ersten und einer zweiten Mikrospiegelvorrichtung.
Figuren 1b.1-1b.4 zeigen schematisch die Verfahrensschritte einer zweiten Ausführungsform eines Verfahrens zur Herstellung von wenigstens einer ersten und einer zweiten Mikrospiegelvorrichtung.
Figur 2 zeigt eine erste Mikrospiegelvorrichtung mit einer ersten und/oder zweiten Spiegelplatte, aufweisend jeweils eine Polysiliziumschicht.

### Ausführungsbeispiele der Erfindung

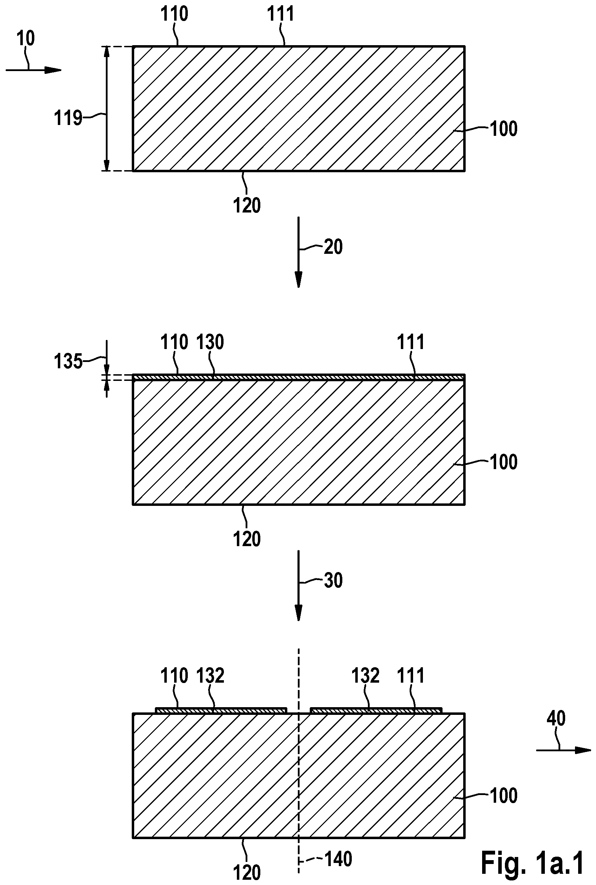

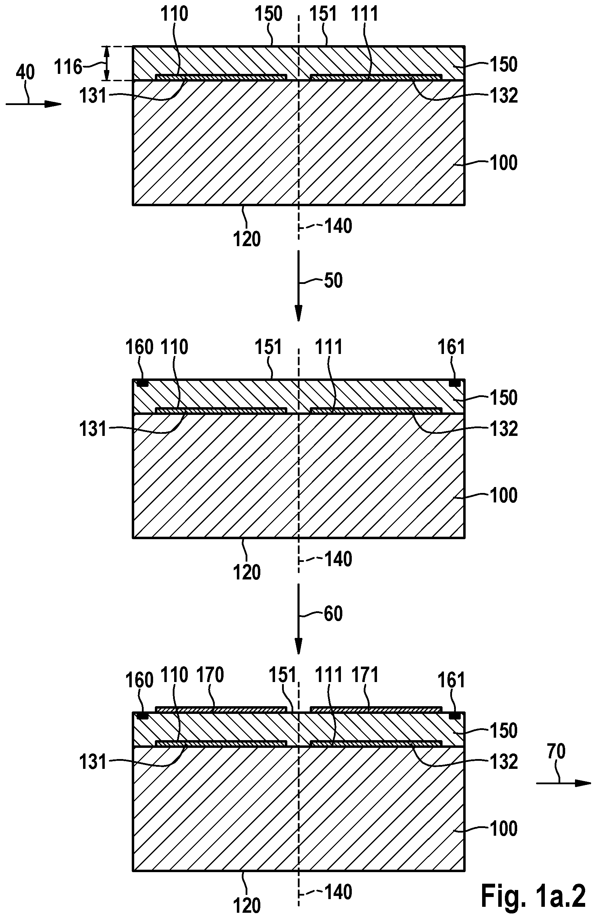

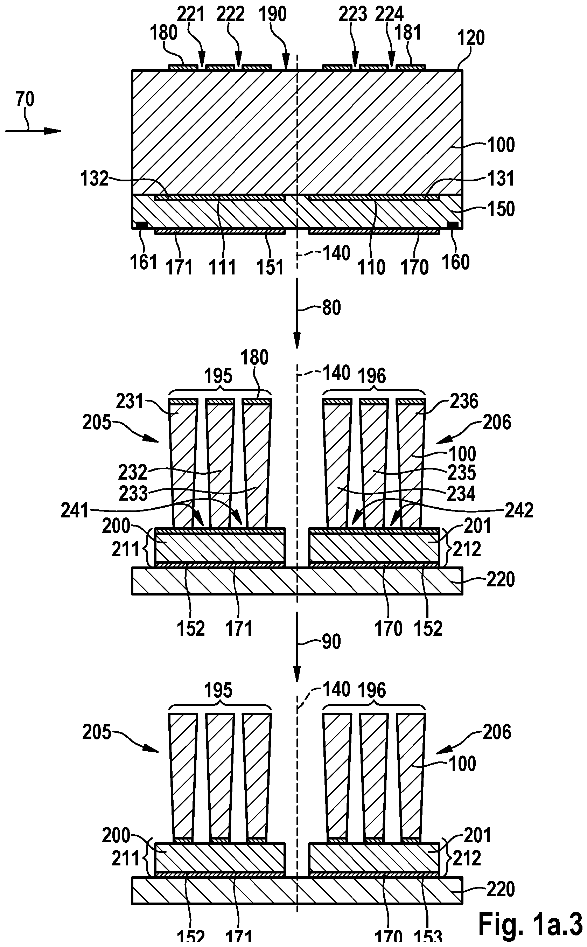

Figur 1a.1 bis 1a.3 zeigen schematisch die Verfahrensschritte einer ersten Ausführungsform eines Verfahrens zur Herstellung von wenigstens einer ersten und einer zweiten Mikrospiegelvorrichtung. Hierbei wird in einem ersten Verfahrensschritt 10 ein, insbesondere plattenförmiger, Siliziumwafer 100 mit einer Vorderseite 110 und einer Rückseite 120 bereitgestellt. In einem folgenden Verfahrensschritt 20 wird
eine Siliziumoxidschicht 130 auf die Vorderseite 110 des Siliziumwafers 100, insbesondere mit einer Schichtdicke 135 der Siliziumoxidschicht 130 von im Wesentlichen 2µm, aufgebracht. In einem folgenden Verfahrensschritt 30 wird die Siliziumoxidschicht 130, insbesondere bis zu einer äußeren Oberfläche 111 des Siliziumwafers 100, derart entfernt, dass ein erster Trennbereich 131 und ein zweiter Trennbereich 132 der Siliziumoxidschicht 130 erzeugt werden. Der erste 131 und der zweite Trennbereich 132 der Siliziumoxidschicht 130 sind hierbei voneinander räumlich, entlang einer Trennebene 140 getrennt angeordnet. In einem folgenden Verfahrensschritt 40 wird eine Siliziumschicht 150, insbesondere mit einer Schichtdicke 116 von im Wesentlichen 20 µm, auf die Vorderseite 110 des Siliziumwafers 100 und auf den ersten 131 und zweiten Trennbereich 132 der Siliziumoxidschicht 130 aufgebacht. In diesem Fall handelt es sich bei der Siliziumschicht 150 um eine Polysiliziumschicht. In einem folgenden Verfahrensschritt 70 wird eine Ätzmaske 180 auf die Rückseite 120 des Siliziumwafers 100 aufgebracht. Die Ätzmaske 180 weist hierbei entlang der Trennebene 140 eine erste Öffnung 190 auf. In diesem Fall handelt es sich bei der Ätzmaske 180 um eine Hardmaske, die aus einer weiteren Siliziumoxidschicht 181 ausgebildet ist und auf die Rückseite 120 des Siliziumwafers aufgebracht wird. In einem folgenden Verfahrensschritt 80 wird dann die Siliziumschicht 150, insbesondere ein Teil der Siliziumschicht 150, und der Siliziumwafer 100, insbesondere ein Teil des Siliziumwafers 100, mittels eines Ätzverfahrens abhängig von der Ätzmaske 180 auf der Rückseite 120 des Siliziumwafers 100 und abhängig von dem ersten 131 und zweiten Trennbereich 132 der Siliziumoxidschicht 130 entfernt, sodass wenigstens eine erste 205 und eine zweite Mikrospiegelvorrichtung 206 erzeugt werden. Der erste 131 und zweite Trennbereich 132 der Siliziumoxidschicht 130 sind hierbei als Ätzstoppschichten ausgebildet.

In dem dargestellten Ausführungsbeispiel wird durch das Entfernen der Siliziumschicht 150 mittels des Ätzverfahrens in Verfahrensschritt 80 wenigstens ein erster Trennbereich 200 und einen zweiter Trennbereich 201 der Siliziumschicht 150 erzeugt. Der erste 200 und der zweite Trennbereich 201 der Siliziumschicht 150 sind ebenfalls voneinander räumlich, entlang der Trennebene 140 getrennt angeordnet. Somit wird eine erste Spiegelplatte 211 der ersten Mikrospiegelvorrichtung 205, aufweisend den ersten Trennbereich 200 der Siliziumschicht 150, und eine zweite Spiegelplatte 212 der zweiten Mikrospiegelvorrichtung 206, aufweisend den zweiten Trennbereich 201 der Siliziumschicht 150, erzeugt.

Weiterhin wird in dem dargestellten Ausführungsbeispiel durch das Entfernen des Siliziumwafers 100 mittels des Ätzverfahrens in Verfahrensschritt 80 ein erster Trennbereich und ein zweiter Trennbereich des Siliziumwafers 100 erzeugt. Der erste und der zweite Trennbereich des Siliziumwafers 100 sind hierbei voneinander räumlich, entlang der Trennebene 140 getrennt angeordnet. Somit wird eine erste Versteifungsstruktur 195 der ersten Mikrospiegelvorrichtung 205, aufweisend den ersten Trennbereich des Siliziumwafers 100 und den ersten Trennbereich 131 der Siliziumoxidschicht 130, und eine zweite Versteifungsstruktur 196 der zweiten Mikrospiegelvorrichtung 206, aufweisend den zweiten Trennbereich des Siliziumwafers 100 und den zweiten Trennbereich 132 der Siliziumoxidschicht 130, erzeugt.

Weiterhin weist in dem dargestellten Ausführungsbeispiel die Ätzmaske 180 eine zweite 221, dritte 222, vierte 223 und fünfte Öffnung 224 auf. Diese Öffnungen sind dazu ausgebildet, die erste 195 und zweite Versteifungsstruktur 196 in weitere Trennbereiche aufzutrennen, welche in dieser Ausführungsform als erste 231, zweite 232, dritte 233, vierte 234, fünfte 235 und sechste 236 Versteifungsstrebe ausgebildet sind.

In der dargestellte, ersten Ausführungsform des Verfahrens wird in Verfahrensschritt 80 als Ätzverfahren ein Plasmaätzverfahren, insbesondere das DRIE-Ätzverfahren, verwendet.

In der dargestellten, ersten Ausführungsform des Verfahrens wird in Verfahrensschritt 10 der Siliziumwafer 100 mit einer Dicke 119 von im Wesentlichen 300 bis 400 µm bereitgestellt.

In einem weiteren Verfahrensschritt 60 wird in dieser ersten Ausführungsform des Verfahrens eine erste Metallschicht 170 auf eine äußere Oberfläche 151 der Siliziumschicht 150 aufgebracht. In diesem Fall ist die erste Metallschicht als eine Goldschicht ausgebildet und diese Goldschicht wird auf einem Bereich der Siliziumschicht 150 aufgebracht, welche später dem ersten Trennbereich 200 der Siliziumschicht 150 entspricht. Weiterhin wird eine zweite Metallschicht 171 auf eine äußere Oberfläche 151der Siliziumschicht 150 aufgebracht. Auch in diesem Fall ist die zweite Metallschicht 171 als eine Goldschicht ausgebildet und diese Goldschicht wird hierbei auf einem Bereich der Siliziumschicht 150 aufgebracht, welche später dem zweiten Trennbereich 201 der Siliziumschicht 150 entspricht. Weiterhin werden in einem auf den Verfahrensschritt 40 folgenden Verfahrensschritt 50 zwei Markierungen 160 und 161 auf der Siliziumschicht 150 aufgebracht. Die zwei Markierungen 160 und 161 werden hierbei in eine äußere Oberfläche 151 der Siliziumschicht 150 geätzt. Diese Markierungen 160 und 161 dienen zur Ausrichtung der ersten Metallschicht 17) relativ zu dem ersten Trennbereich 131 der Siliziumoxidschicht 130 und zur Ausrichtung der zweiten Metallschicht 171 relativ zu dem wenigstens zweiten Trennbereich 132 der Siliziumoxidschicht. Um die Markierungen 160 und 161 in der richtigen Position auf die Siliziumschicht 150 aufzubringen, wird hierzu ein hier nicht dargestelltes Infrarotmessgerät verwendet, mittels welchem der innerhalb des Schichtstapels, aufweisend den Siliziumwafer 100 und die Siliziumschicht, vergrabene erste Trennbereich 131 und zweite Trennbereich 132 der Siliziumoxidschicht 130 detektiert werden kann. Die zwei Markierungen 131 und 132 werden dann insbesondere auf einem Randbereich des Schichtstapels aufgebracht.

Weiterhin wird eine äußere Oberfläche 152 des ersten Trennbereichs 200 der Siliziumschicht 150 und eine äußere Oberfläche 153 des zweiten Trennbereichs 201 der Siliziumschicht mittelbar mit einem Klebeband 220 verbunden. In dem dargestellten Fall sind die erste 170 und zweite Metallschicht 171 unmittelbar mit dem Klebeband 220 stoffschlüssig verbunden. Das Klebeband 220 dient in dem dargestellten Ausführungsbeispiel zum einen als Ätzstoppschicht während des Ätzprozesses in Verfahrensschritt 80. Zum anderen dient das Klebeband 220, welches insbesondere als einseitiges Klebeband ausgebildet ist, dazu, die fertig hergestellten ersten und zweiten Mikrospiegelvorrichtungen zu der hier nicht dargestellten jeweiligen Antriebseinheit, insbesondere piezoelektrischen Antriebseinheit, des Mikrospiegels zu transportieren.

In einem weiteren Verfahrensschritt 90 wird die Ätzmaske 180, welche hierbei als Hardmaske ausgebildet ist, mittels eines Oxidätzprozesses entfernt. Hierbei werden ebenfalls die freiliegenden Bereiche 241 des ersten Trennbereichs 131 der Siliziumoxidschicht 130 und die freiliegenden Bereiche 242 des zweiten Trennbereichs 132 der Siliziumoxidschicht 130 weggeätzt.

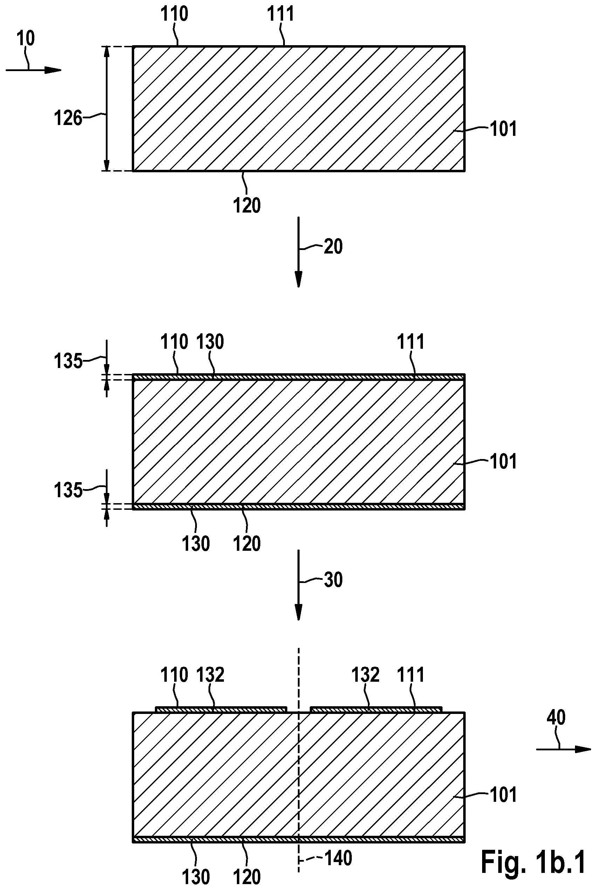

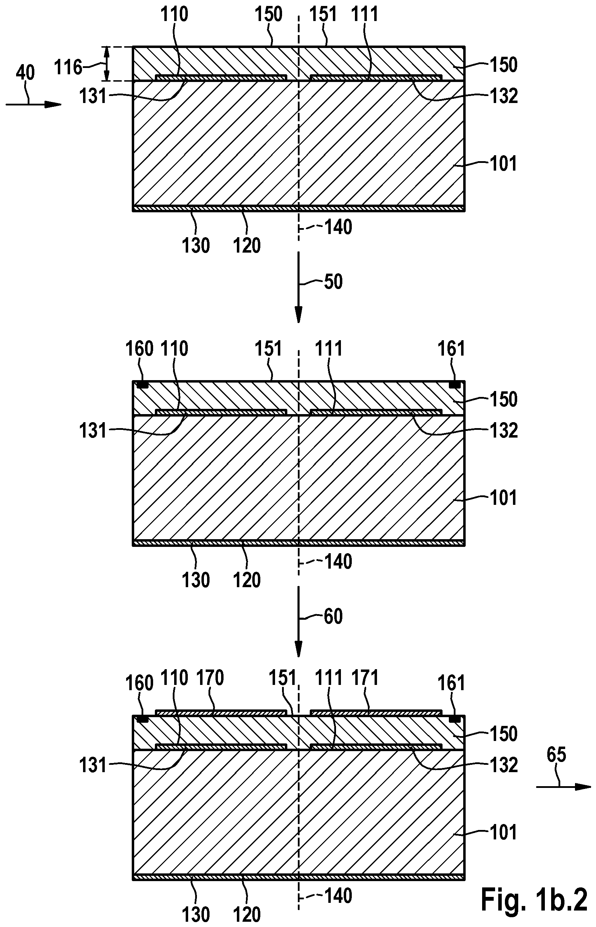

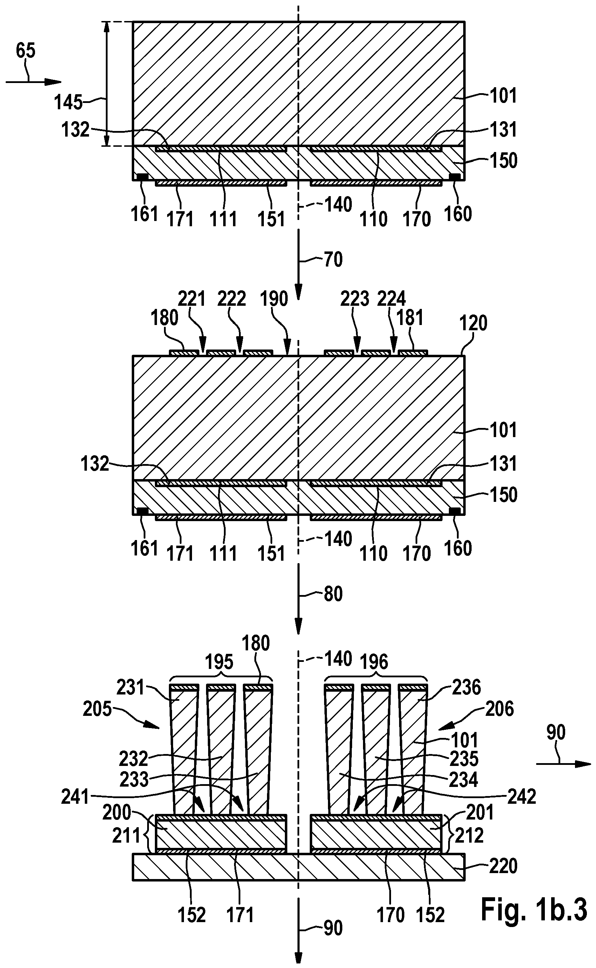

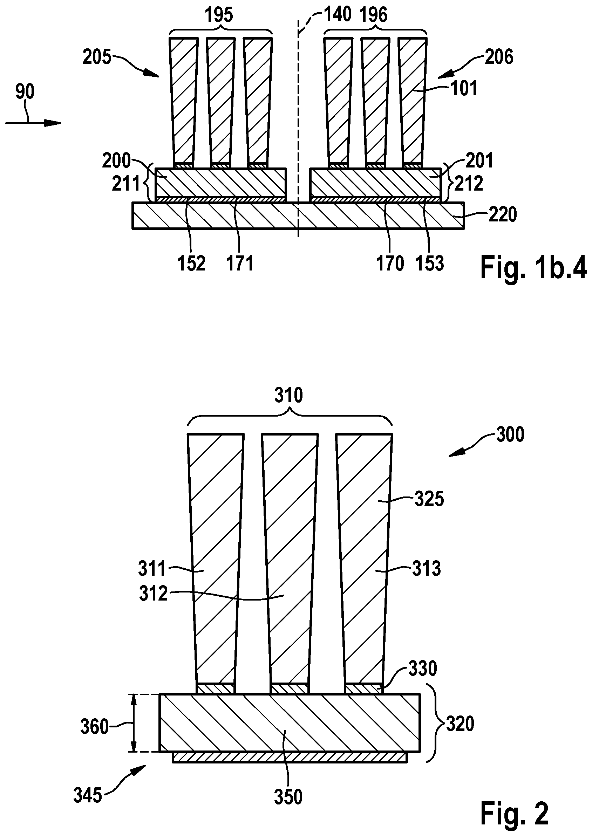

Auf Figuren 1b.1 bis 1b.4 werden schematisch die Verfahrensschritte einer zweiten Ausführungsform eines Verfahrens zur Herstellung von wenigstens einer ersten und einer zweiten Mikrospiegelvorrichtung gezeigt. Im Unterschied zu der ersten Ausführungsform wird hierbei in Verfahrensschritt 11 ein Siliziumwafer 101 mit einer Dicke 126 von im Wesentlichen 725 µm bereitgestellt. Zudem wird in dem folgenden Verfahrensschritt 20 nicht nur auf die Vorderseite 110 des Siliziumwafers 101 eine Siliziumoxidschicht 130 aufgebracht, sondern zusätzlich auch auf die Rückseite 120 des Siliziumwafers 101. Weiterhin wird im Unterschied zu der ersten Ausführungsform des Verfahrens in einem Verfahrensschritt 65, welcher auf den Verfahrensschritt 60 folgt, die Rückseite 120 des Siliziumwafers 101 abgeschliffen, bis eine Zieldicke 145 des Siliziumwafers 101 erreicht ist. Die Zieldicke 145 entspricht hierbei eine Dicke des Siliziumwafers 101 von im Wesentlichen 300 µm bis 400 µm.

Figur 2 zeigt eine erste Mikrospiegelvorrichtung 300, welche insbesondere mittels eines der in Figuren 1a.1-1a.3 oder Figuren 1b.1-1b.4 beschriebenen Verfahren hergestellt wird. Die Mikrospiegelvorrichtung 300 weist hierbei eine Versteifungsstruktur 310 auf, welche hierbei in eine erste 311, zweite 312 und dritte Versteifungsstrebe 313 aufgetrennt ist. Jede Versteifungsstrebe 311, 312 und 313 weist einen Teil eines ersten Trennbereichs 325 eines Siliziumwafers und einen Teil eines ersten Trennbereichs 330 einer Siliziumoxidschicht auf. Die Versteifungsstreben 311, 312 und 313 können ebenfalls über hier nicht dargestellte Querstreben miteinander verbunden sein. Weiterhin weist die erste Mikrospiegelvorrichtung 300 eine erste Spiegelplatte 320 auf. Diese Spiegelplatte 320 weist hierbei einen ersten Trennbereich 345 einer Siliziumschicht 350 auf. Die Siliziumschicht 350 ist hierbei als Polysiliziumschicht ausgebildet. In dem dargestellten Fall weist die Polysiliziumschicht eine Schichtdicke 360 von im Wesentlichen 20 µm auf.

## Patentansprüche

1. Verfahren zur Herstellung von wenigstens einer ersten (205, 300) und einer zweiten Mikrospiegelvorrichtung (206), wobei das Verfahren die folgenden Verfahrensschritte aufweist:
- Bereitstellen (10, 11) eines, insbesondere plattenförmigen, Siliziumwafers (100, 101) mit einer Vorderseite (110) und einer Rückseite (120), und
- Aufbringen (20) von einer Siliziumoxidschicht (130) auf wenigstens die Vorderseite (110) des Siliziumwafers (100, 101), insbesondere mit einer Schichtdicke (135) der Siliziumoxidschicht (130) in einem Bereich von 1 µm bis 3 µm, und
- Entfernen (30) der Siliziumoxidschicht (130, insbesondere bis zu einer äußeren Oberfläche (111) des Siliziumwafers (100, 101), derart, dass wenigstens ein erster Trennbereich (131) und wenigstens ein zweiter Trennbereich (132) der Siliziumoxidschicht (130) erzeugt werden, wobei der erste (131) und der zweite Trennbereich (132) der Siliziumoxidschicht (130) voneinander räumlich, entlang einer Trennebene (140) getrennt angeordnet sind, und
- Aufbringen (40) einer Siliziumschicht (150, 350), insbesondere einer Polysiliziumschicht mit einer Schichtdicke (116) in einem Bereich von 5 µm bis 50 µm, auf die Vorderseite (110) des Siliziumwafers (100, 101) und auf die Siliziumoxidschicht (130), insbesondere auf den ersten (131) und zweiten Trennbereich (132) der Siliziumoxidschicht (130), und
- Aufbringen (70) einer Ätzmaske (180) auf die Rückseite (120) des Siliziumwafers (100), wobei die Ätzmaske (180) entlang der Trennebene (140) des ersten (131) und zweiten Trennbereichs (132) der Siliziumoxidschicht (130) eine erste Öffnung (190) aufweist, und
- Entfernen (80) der Siliziumschicht (150, 350) und des Silliziumwafers (100, 101) mittels eines Ätzverfahrens in einem Verfahrensschritt abhängig von der Ätzmaske (180) auf der Rückseite (120) des Siliziumwafers (100, 101) und abhängig von der Siliziumoxidschicht (130) des Siliziumwafers (100, 101), insbesondere des ersten (131) und zweiten Trennbereichs (132) der Siliziumoxidschicht (130), sodass wenigstens eine erste (205, 300) und eine zweite Mikrospiegelvorrichtung (206) erzeugt werden.

2. Verfahren nach Anspruch 1, **dadurch gekennzeichnet, dass** durch das Entfernen (80) der Siliziumschicht (150, 350) mittels des Ätzverfahrens wenigstens ein erster Trennbereich (200, 345) und einen zweiter Trennbereich (201) der Siliziumschicht (150, 350) erzeugt werden, wobei der erste (200) und der zweite Trennbereich (201) der Siliziumschicht (150, 350) voneinander räumlich, entlang der Trennebene (140) getrennt angeordnet sind, wobei somit eine erste Spiegelplatte (211, 320), der ersten Mikrospiegelvorrichtung (205, 300), aufweisend den ersten Trennbereich (200, 345) der Siliziumschicht (150, 350), und eine zweite Spiegelplatte (212) der zweiten Mikrospiegelvorrichtung (206), aufweisend den zweiten Trennbereich (201) der Siliziumschicht (150, 350), erzeugt werden.

3. Verfahren gemäß einem der Ansprüche 1 oder 2, **dadurch gekennzeichnet, dass** durch das Entfernen (80) des Siliziumwafers (100, 101) mittels des Ätzverfahrens wenigstens ein erster Trennbereich und einen zweiter Trennbereich des Siliziumwafers (100, 101) erzeugt werden, wobei der erste und der zweite Trennbereich des Siliziumwafers (100, 101) voneinander räumlich, entlang der Trennebene getrennt angeordnet sind, wobei somit eine erste Versteifungsstruktur (195, 310) der ersten Mikrospiegelvorrichtung (205, 300), aufweisend den ersten Trennbereich des Siliziumwafers (100, 101) und den ersten Trennbereich (131) der Siliziumoxidschicht (130), und eine zweite Versteifungsstruktur (196) der zweiten Mikrospiegelvorrichtung (206), aufweisend den zweiten Trennbereich des Siliziumwafers (100, 101) und den zweiten Trennbereich der Siliziumoxidschicht (100, 101), erzeugt werden.

4. Verfahren gemäß Anspruch 3, **dadurch gekennzeichnet, dass** die Ätzmaske (180) wenigstens eine zweite Öffnung (221), insbesondere zur Trennung der ersten Versteifungsstruktur (195, 310) in einen ersten Trennbereich, insbesondere eine erste Versteifungsstrebe (231, 311) der ersten Versteifungsstruktur (195, 310) und einen zweiten Trennbereich, insbesondere eine zweite Versteifungsstrebe (232, 312), der ersten Versteifungsstruktur (195, 310) aufweist.

5. Verfahren gemäß einem der Ansprüche 1 bis 4, **dadurch gekennzeichnet, dass** als Ätzverfahren ein Plasmaätzverfahren, insbesondere das DRIE-Ätzverfahren, verwendet wird.

6. Verfahren gemäß einem der Ansprüche 1 bis 5, **dadurch gekennzeichnet, dass** der Siliziumwafer (100) mit einer Dicke (119) von im Wesentlichen 300 bis 400 µm bereitgestellt (10) wird.

7. Verfahren gemäß einem der Ansprüche 1 bis 5, **dadurch gekennzeichnet, dass** der Siliziumwafer (101) mit einer Dicke (126) von im Wesentlichen 725 µm bereitgestellt (11) wird.

8. Verfahren gemäß Anspruch 7, **dadurch gekennzeichnet, dass** in einem weiteren Verfahrensschritt, insbesondere folgend auf das Aufbringen (60) der Siliziumschicht (150 350), insbesondere der Polysiliziumschicht, auf die Vorderseite (110) des Siliziumwafers (100, 101) und auf die Siliziumoxidschicht (130), die Rückseite (120) des Siliziumwafers (100, 101), insbesondere bis zu einem Erreichen einer Zieldicke (145) des Siliziumwafers (100, 101), abgeschliffen (65) wird.

9. Verfahren gemäß einem der Ansprüche 1 bis 8, **dadurch gekennzeichnet, dass** die Siliziumoxidschicht (130) zusätzlich auf die Rückseite (120) des Siliziumwafers (100, 101) aufgebracht (20) wird.

10. Verfahren gemäß einem der Ansprüche 1 bis 9, **dadurch gekennzeichnet, dass** in einem weiteren Verfahrensschritt eine erste Metallschicht (170), insbesondere eine erste Goldschicht oder eine erste Aluminiumschicht, auf die Siliziumschicht (150, 350), insbesondere auf eine äußere Oberfläche (152) des ersten Trennbereichs (200, 345) der Siliziumschicht (150, 350), aufgebracht wird, und eine zweite Metallschicht (171), insbesondere eine zweite Goldschicht oder eine zweite Aluminiumschicht, auf die Siliziumschicht (150, 350), insbesondere auf eine äußere Oberfläche (153) des zweiten Trennbereichs (201) der Siliziumschicht (150, 350), aufgebracht (60) wird.

11. Verfahren gemäß Anspruch 10, **dadurch gekennzeichnet, dass** Verfahren gemäß einem der Ansprüche 1 bis 9, **dadurch gekennzeichnet, dass** zur Ausrichtung der ersten Metallschicht (170) relativ zu dem ersten Trennbereich (131) der Siliziumoxidschicht (130) und zur Ausrichtung der zweiten Metallschicht (171) relativ zu dem wenigstens zweiten Trennbereich (132) der Siliziumoxidschicht (130) wenigstens zwei Markierungen (160, 161) auf der Siliziumschicht (150, 350) aufgebracht werden.

12. Verfahren gemäß einem der Ansprüche 1 bis 11, **dadurch gekennzeichnet, dass** die Siliziumschicht (150, 350), insbesondere die äußere Oberfläche (152) des ersten Trennbereichs (200, 345) der Siliziumschicht (150, 350) und die äußere Oberfläche (153) des zweiten Trennbereichs (201) der Siliziumschicht (150, 350), unmittelbar oder mittelbar mit einem Klebeband (220), insbesondere einem einseitigen Klebeband, verbunden wird.

13. Verfahren gemäß einem der Ansprüche 1 bis 12, **dadurch gekennzeichnet, dass** in einem weiteren Verfahrensschritt die Ätzmaske (180) entfernt (90) wird.

14. Verfahren gemäß einem der Ansprüche 1 bis 13, **dadurch gekennzeichnet, dass** die Siliziumschicht (150, 350) in Form einer Abscheidung von Silizium, insbesondere Polysilizium, auf der Vorderseite (110) des Siliziumwafers (100, 101) und auf der Siliziumoxidschicht (130), insbesondere auf den ersten (131) und zweiten Trennbereich (132) der Siliziumoxidschicht (130), und einem Polierschritt, insbesondere des abgeschiedenen Siliziums, aufgebracht wird.

## Claims

1. Process for producing at least a first (205, 300) and a second micromirror device (206), wherein the process comprises the following process steps:
- providing (10, 11) a silicon wafer (100, 101), in particular plate-shaped, having a front (110) and a rear (120), and
- applying (20) a silicon oxide layer (130) to at least the front (110) of the silicon wafer (100, 101), in particular with a layer thickness (135) of the silicon oxide layer (130) in a range from 1 µm to 3 µm, and
- removing (30) the silicon oxide layer (130), in particular up to an outer surface (111) of the silicon wafer (100, 101), such that at least one first separation region (131) and at least a second separation region (132) of the silicon oxide layer (130) are produced, wherein the first (131) and the second separation region (132) of the silicon oxide layer (130) are arranged separately from each other spatially, along a separation plane (140), and
- applying (40) a silicon layer (150, 350), in particular a polysilicon layer having a layer thickness (116) in a range from 5 µm to 50 µm, to the front (110) of the silicon wafer (100, 101) and to the silicon oxide layer (130), in particular to the first (131) and second (132) separation regions of the silicon oxide layer (130), and
- applying (70) an etching mask (180) to the rear (120) of the silicon wafer (100), wherein the etching mask (180) has a first opening (190) along the separation plane (140) of the first (131) and second (132) separation regions of the silicon oxide layer (130), and
- removing (80) the silicon layer (150, 350) and the silicon wafer (100, 101) by means of an etching process in one process step depending on the etching mask (180) on the rear (120) of the silicon wafer (100, 101) and depending on the silicon oxide layer (130) of the silicon wafer (100, 101), in particular the first (131) and second (132) separation regions of the silicon oxide layer (130), so that at least a first (205, 300) and a second micromirror device (206) are produced.

2. Process according to Claim 1, **characterized in that** by removing (80) the silicon layer (150, 350) by means of the etching process, at least a first separation region (200, 345) and a second separation region (201) of the silicon layer (150, 350) are produced, wherein the first (200) and the second (201) separation regions of the silicon layer (150, 350) are arranged separately from each other spatially, along the separation plane (140), so that a first mirror plate (211, 320) of the first micromirror device (205, 300), comprising the first separation region (200, 345) of the silicon layer (150, 350), and a second mirror plate (212) of the second micromirror device (206), comprising the second separation region (201) of the silicon layer (150, 350), are produced.

3. Process according to either of Claims 1 or 2, **characterized in that** by removing (80) the silicon wafer (100, 101) by means of the etching process, at least a first separation region and a second separation region of the silicon wafer (100, 101) are produced, wherein the first and the second separation regions of the silicon wafer (100, 101) are arranged separately from each other spatially, along the separation plane, so that a first stiffening structure (195, 310) of the first micromirror device (205, 300), comprising the first separation region of the silicon wafer (100, 101) and the first separation region (131) of the silicon oxide layer (130), and a second stiffening structure (196) of the second micromirror device (206), comprising the second separation region of the silicon wafer (100, 101) and the second separation region of the silicon oxide layer (100, 101), are produced.

4. Process according to Claim 3, **characterized in that** the etching mask (180) has at least a second opening (221), in particular for separating the first stiffening structure (195, 310) into a first separation region, in particular a first stiffening strut (231, 311) of the first stiffening structure (195, 310) and a second separation region, in particular a second stiffening strut (232, 312) of the first stiffening structure (195, 310).

5. Process according to any of Claims 1 to 4, **characterized in that** the etching process used is a plasma etching process, in particular the DRIE etching process.

6. Process according to any of Claims 1 to 5, **characterized in that** the silicon wafer (100) provided (10) has a thickness (119) of substantially 300 to 400 µm.

7. Process according to any of Claims 1 to 5, **characterized in that** the silicon wafer (101) provided (11) has a thickness (126) of substantially 725 µm.

8. Process according to Claim 7, **characterized in that**, in a further process step, in particular subsequent to the application (60) of the silicon layer (150, 350), in particular the polysilicon layer, to the front (110) of the silicon wafer (100, 101) and to the silicon oxide layer (130), the rear (120) of the silicon wafer (100, 101) is abraded (65), in particular until a target thickness (145) of the silicon wafer (100, 101) is reached.

9. Process according to any of Claims 1 to 8, **characterized in that** the silicon oxide layer (130) is additionally applied (20) to the rear (120) of the silicon wafer (100, 101).

10. Process according to any of Claims 1 to 9, **characterized in that** in a further process step, a first metal layer (170), in particular a first gold layer or a first aluminium layer, is applied to the silicon layer (150, 350), in particular to an outer surface (152) of the first separation region (200, 345) of the silicon layer (150, 350), and a second metal layer (171), in particular a second gold layer or a second aluminium layer, is applied (60) to the silicon layer (150, 350), in particular to an outer surface (153) of the second separation region (201) of the silicon layer (150, 350).

11. Process according to Claim 10, **characterized in that** process according to any of Claims 1 to 9, **characterized in that** for the orientation of the first metal layer (170) relative to the first separation region (131) of the silicon oxide layer (130) and for the orientation of the second metal layer (171) relative to the at least second separation region (132) of the silicon oxide layer (130), at least two marks (160, 161) are applied on the silicon layer (150, 350).

12. Process according to any of Claims 1 to 11, **characterized in that** the silicon layer (150, 350), in particular the outer surface (152) of the first separation region (200, 345) of the silicon layer (150, 350) and the outer surface (153) of the second separation region (201) of the silicon layer (150, 350), is connected directly or indirectly with an adhesive tape (220), in particular a single-sided adhesive tape.

13. Process according to any of Claims 1 to 12, **characterized in that** in a further process step, the etching mask (180) is removed (90).

14. Process according to any of Claims 1 to 13, **characterized in that** the silicon layer (150, 350) is applied in the form of a deposition of silicon, in particular polysilicon, on the front (110) of the silicon wafer (100, 101) and on the silicon oxide layer (130), in particular on the first (131) and second (132) separation regions of the silicon oxide layer (130), and a polishing step, in particular of the deposited silicon.

## Revendications

1. Procédé de fabrication d'au moins un premier (205, 300) et un deuxième (206) dispositif à micro-miroir, le procédé comprenant les étapes suivantes :
- prévoir (10, 11) une tranche de silicium (100, 101), en particulier en forme de plaque, ayant une face avant (110) et une face arrière (120), et
- appliquer (20) une couche d'oxyde de silicium (130) sur au moins la face avant (110) de la tranche de silicium (100, 101), en particulier avec une épaisseur de couche (135) de la couche d'oxyde de silicium (130) située dans une gamme allant de 1µm à 3µm, et
- éliminer (30) la couche d'oxyde de silicium (130), en particulier jusqu'à une surface extérieure (111) de la tranche de silicium (100, 101), de telle sorte qu'au moins une première zone de séparation (131) et au moins une deuxième zone de séparation (132) de la couche d'oxyde de silicium (130) soient produites, la première (131) et la deuxième zone de séparation (132) de la couche d'oxyde de silicium (130) étant aménagées de façon spatialement séparée l'une de l'autre, le long d'un plan de séparation (140), et
- appliquer (40) une couche de silicium (150, 350), en particulier d'une couche de polysilicium ayant une épaisseur de couche (116) située dans une gamme allant de 5µm à 50µm, sur la face avant (110) de la tranche de silicium (100, 101) et sur la couche d'oxyde de silicium (130), en particulier sur la première (131) et la deuxième zone de séparation (132) de la couche d'oxyde de silicium (130), et
- appliquer (70) un masque de gravure (180) sur la face arrière (120) de la tranche de silicium (100), le masque de gravure (180) présentant une première ouverture (190) le long du plan de séparation (140) de la première (131) et de la deuxième (132) zone de séparation de la couche d'oxyde de silicium (130), et
- éliminer (80) la couche de silicium (150, 350) et la tranche de silicium (100, 101) au moyen d'un procédé de gravure en une étape de procédé en fonction du masque de gravure (180) sur la face arrière (120) de la tranche de silicium (100, 101) et en fonction de la couche d'oxyde de silicium (130) de la tranche de silicium (100, 101), en particulier des première (131) et deuxième (132) zones de séparation de la couche d'oxyde de silicium (130), de sorte qu'au moins un premier (205, 300) et un deuxième dispositif à micro-miroir (206) soient produits.

2. Procédé selon la revendication 1, **caractérisé en ce que**, par l'élimination (80) de la couche de silicium (150, 350) au moyen du procédé de gravure, il est produit au moins une première zone de séparation (200, 345) et une deuxième zone de séparation (201) de la couche de silicium (150, 350), la première (200) et la deuxième (201) zone de séparation de la couche de silicium (150, 350) étant aménagées de façon spatialement espacée l'une de l'autre, le long du plan de séparation (140), créant ainsi une première plaque miroir (211, 320) du premier dispositif à micro-miroir (205, 300), comprenant la première zone de séparation (200, 345) de la couche de silicium (150, 350), et une deuxième plaque miroir (212) du deuxième dispositif à micro-miroir (206), comprenant la deuxième zone de séparation (201) de la couche de silicium (150, 350).

3. Procédé selon l'une des revendications 1 ou 2, **caractérisé en ce que**, par l'élimination (80) de la tranche de silicium (100, 101) au moyen du procédé de gravure, il est généré au moins une première zone de séparation et une deuxième zone de séparation de la tranche de silicium (100, 101), la première et la deuxième zone de séparation de la tranche de silicium (100, 101) étant aménagées de façon spatialement séparée l'une de l'autre le long du plan de séparation, une première structure de renforcement (195, 310) du premier dispositif à micro-miroir (205, 300), comprenant la première zone de séparation de la tranche de silicium (100, 101) et la première zone de séparation (131) de la couche d'oxyde de silicium (130), et une deuxième structure de renforcement (196) du deuxième dispositif à micro-miroir (206), comprenant la deuxième zone de séparation de la tranche de silicium (100, 101) et la deuxième zone de séparation de la couche d'oxyde de silicium (100, 101), étant ainsi générées.

4. Procédé selon la revendication 3, **caractérisé en ce que** le masque de gravure (180) comporte au moins une deuxième ouverture (221), notamment pour séparer la première structure de rigidification (195, 310) en une première zone de séparation, notamment une première entretoise de rigidification (231, 311) de la première structure de rigidification (195, 310) et une deuxième zone de séparation, notamment une deuxième entretoise de rigidification (232, 312) de la première structure de rigidification (195, 310).

5. Procédé selon l'une des revendications 1 à 4, **caractérisé en ce que** le procédé de gravure utilisé est un procédé de gravure par plasma, notamment le procédé de gravure DRIE.

6. Procédé selon l'une des revendications 1 à 5, **caractérisé en ce que** la tranche de silicium (100) est fournie (10) avec une épaisseur (119) sensiblement comprise entre 300 et 400µm.

7. Procédé selon l'une des revendications 1 à 5, **caractérisé en ce que** la tranche de silicium (101) est prévue (11) avec une épaisseur (126) sensiblement égale à 725µm.

8. Procédé selon la revendication 7, **caractérisé en ce que**, dans une autre étape du procédé, notamment consécutive au dépôt (60) de la couche de silicium (150, 350), notamment de la couche de polysilicium, sur la face avant (110) de la tranche de silicium (100, 101) et sur la couche d'oxyde de silicium (130), la face arrière (120) de la tranche de silicium (100, 101) est meulée (65), notamment jusqu'à atteindre une épaisseur cible (145) de la tranche de silicium (100, 101).

9. Procédé selon l'une des revendications 1 à 8, **caractérisé en ce que** la couche d'oxyde de silicium (130) est en outre appliquée (20) sur la face arrière (120) de la tranche de silicium (100, 101).

10. Procédé selon l'une des revendications 1 à 9, **caractérisé en ce que**, dans une étape supplémentaire du procédé, une première couche métallique (170), en particulier une première couche d'or ou une première couche d'aluminium, est appliquée sur la couche de silicium (150, 350), en particulier sur une surface extérieure (152) de la première zone de séparation (200, 345) de la couche de silicium (150, 350), et une deuxième couche métallique (171), notamment une deuxième couche d'or ou une deuxième couche d'aluminium, est appliquée (60) sur la couche de silicium (150, 350), notamment sur une surface extérieure (153) de la deuxième zone de séparation (201) de la couche de silicium (150, 350).

11. Procédé selon la revendication 10, **caractérisé en ce que** procédé selon l'une des revendications 1 à 9, **caractérisé en ce que**, pour aligner la première couche métallique (170) par rapport à la première zone de séparation (131) de la couche d'oxyde de silicium (130) et pour aligner la deuxième couche métallique (171) par rapport à au moins la deuxième zone de séparation (132) de la couche d'oxyde de silicium (130), au moins deux repères (160, 161) sont déposés sur la couche de silicium (150, 350).

12. Procédé selon l'une des revendications 1 à 11, **caractérisé en ce que** la couche de silicium (150, 350), notamment la surface extérieure (152) de la première zone de séparation (200, 345) de la couche de silicium (150, 350) et la surface extérieure (153) de la deuxième zone de séparation (201) de la couche de silicium (150, 350), est liée directement ou indirectement par un ruban adhésif (220), notamment un ruban adhésif simple face.

13. Procédé selon l'une des revendications 1 à 12, **caractérisé en ce que**, dans une autre étape du procédé, le masque de gravure (180) est retiré (90).

14. Procédé selon l'une des revendications 1 à 13, **caractérisé en ce que** la couche de silicium (150, 350) est appliquée sous forme d'un dépôt de silicium, notamment de polysilicium, sur la face avant (110) de la tranche de silicium (100, 101) et sur la couche d'oxyde de silicium (130), notamment sur les première (131) et deuxième (132) zones de séparation de la couche d'oxyde de silicium (130), et une étape de polissage, notamment du silicium appliqué.
